# EUROPÄISCHE PATENTANMELDUNG

(11) **EP 0 981 150 A2**
(43) Veröffentlichungstag der Anmeldung: **23.02.2000**
(21) Anmeldenummer: 99111632.8
(22) Anmeldetag: 16.06.1999
(51) Int. Cl.: H01J 37/34

(54) **Vorrichtung zum Beschichten von Substraten mit dünnen Schichten**

(30) Priorität: 14.08.1998 DE 19837045
(71) Anmelder: Leybold Systems GmbH, 63450 Hanau (DE)
(72) Erfinder: Adam, Rolf, 63450 Hanau (DE)

(57) **Zusammenfassung**

Bei einer Vorrichtung zum Beschichten von Substraten (2) mit dünnen Schichten ist das Target (3, 4) als rotationssymmetrischer Körper ausgeformt, der das Substrat (2) ringförmig umschließt, wobei das Target (3) ein Hohlzylinder ist, dessen eine stirnseitige Öffnung verschlossen ist, wobei zwei jeweils einen geschlossenen Ring bildende Reihen von Permanentmagneten (5, 6) vorgesehen sind, von denen die erste geschlossene Reihe (5) die kreiszylindrische Partie des Targets (3) mit Abstand umschließt und die zweite geschlossene Reihe (6) mit Abstand zum die Bodenpartie des Targets (3) bildenden Kreisscheibenstück (4) und koaxial zur Rotationsachse (R) des Hohlzylinders (3) angeordnet ist, wobei jeweils beide Magnetreihen (5, 6) mit einem Joch (7 bzw. 8) aus ferromagnetischem Werkstoff zusammenwirken, deren Polschuhe (9a, 9b bzw. 10a, 10b) jeweils an einem das zylindrische (3) und das den Boden bildende kreisscheibenförmige Stück (4) des Targets (3, 4) von außen einhüllenden Gehäuse (11) aus nichtmagnetischem Werkstoff anliegen.

## Beschreibung

Die Erfindung betrifft eine Vorrichtung zum Beschichten von Substraten mit dünnen Schichten mit einer Vakuumkammer, einem zu zerstäubenden Target, mit Magneten zur Erzeugung eines magnetischen Tunnels vor der zu zerstäubenden Fläche des Targets, einem Einlaß für ein Prozeßgas in den Prozeßraum, einer Anode und mit einer Strom-Spannungs-Versorgung zur Erzeugung eines Plasmas vor dem Target, wobei das Target als rotationssymmetrischer Körper ausgeformt ist und das Substrat ringförmig umschließt.

Bekannt ist eine Einrichtung zur Durchführung vakuumtechnologischer Prozesse in magnetfeldverstärkten elektrischen Entladungen (DD 123 952), bestehend aus einer magnetfelderzeugenden Einrichtung und einem Target mit negativem Potential und einer Anode, zwischen denen die elektrische Entladung brennt, wobei die magnetfelderzeugende Einrichtung mit ihren Polschuhen ringförmig und konzentrisch zur Kathode ausgebildet ist und entsprechend dem durchzuführenden vakuumtechnologischen Prozeß im Inneren des rohrförmigen Targets oder außen herum angeordnet ist und in Achsenrichtung begrenzte inhomogene, torusförmige Magnetfelder erzeugt, deren Hauptfeldrichtung im Bereich des Targets parallel zu dessen Achsenrichtung gerichtet ist und die Anode bei Anordnung der magnetfelderzeugenden Einrichtung im Target dieses rohrförmig umgibt und bei Anordnung um das Target in diesem als Rohr oder Vollmaterial angeordnet ist, wobei die magnetfelderzeugende Einrichtung, das rohrförmige Target und die Anode relativ zueinander bewegbar sind.

Bekannt ist weiterhin eine Einrichtung zum Hochratezerstäuben nach dem Plasmatronprinzip (DD 217 964 A3), bestehend aus einer magnetfelderzeugenden Einrichtung mit Ringspalt, einem gekühlten rohrförmigen Target und einer Anode, wobei die magnetfelderzeugende Einrichtung einen in sich geschlossenen, langgestreckten Ringspalt besitzt, in dem das Target so angeordnet ist, daß ihre große Achse parallel zur Targetachse verläuft, wobei eine Anode das Target so umgibt, daß der Ringspaltbereich frei ist und mittels einer Verstelleinrichtung der Abstand zwischen der Anode und der Targetoberfläche auf einen festen wert einstellbar ist und zum Erzeugen einer Relativbewegung um die große Achse zwischen dem Target und der magnetfelderzeugenden Einrichtung ein Antrieb angeordnet ist und an der magnetfelderzeugende Einrichtung eine Vorrichtung zur Veränderung des Abstandes zwischen dieser und dem Target angeordnet ist.

Weiterhin ist eine Kathode zur Vakuumzerstäubung bekannt (EP 0 461 035 B1), umfassend einen Hohlkörper im wesentlichen in Form eines Rotationskörpers, welcher um seine Achse rotieren kann, mit einer Seitenwand, die sich entlang der Achse erstreckt, und zwei Stirnseiten im wesentlichen senkrecht zur Achse, wobei der Hohlkörper mindestens am Äußeren seiner Seitenwand aus zu zerstäubendem Material gebildet ist, mit einem Magnetkreis zum magnetischen Einschluß, der nahe einem Target vorgesehen ist, und Pole, Teile aus magnetisch-permeablem Metall und Magnetisiermittel, die zur Erzeugung eines magnetischen Flusses in dem Magnetkreis geeignet sind, und mit einer Einrichtung zur Verbindung mit einem Kühlkreis für die Zirkulierung einer Kühlflüssigkeit in dem Hohlkörper, mit einer Einrichtung zur Verbindung mit einem elektrischen Versorgungskreis, und mit einer Triebeinrichtung zur Drehung des Hohlkörpers um eine Achse, wobei der Magnetkreis sich peripher in Bezug auf den Hohlkörper erstreckt, das Magnetisiermittel außerhalb diesem vorgesehen ist, die Pole des Magnetkreises entlang zweier Erzeugenden dieses Hohlkörpers vorgesehen sind und einen Bogen der Seitenwand des Hohlkörpers, der sich zwischen diesen beiden Erzeugenden befindet, das Target der Kathode bildet.

Schließlich hat man bereits eine Vorrichtung zur Aufstäubung von dünnen Filmen eines ausgewählten Überzugsmaterials auf wesentlich planare Substrate vorgeschlagen (EP 0 070 899 B1), bestehend aus einer evakuierbaren Beschichtungskammer, einer in dieser Beschichtungskammer horizontal angebrachten Kathode mit einem länglichen, zylindrischen Rohrelement, auf dessen äußerer Fläche eine Schicht des zu zerstäubenden Überzugsmaterials aufgetragen ist und mit Magnetmitteln, die in diese Rohrelement angeordnet sind, um eine sich in Längsrichtung davon erstreckende Zerstäubungszone vorzusehen, wobei Mittel zum Drehen dieses Rohrelements um seine Längsachse vorgesehen sind, um verschiedene Teile des Überzugsmaterials in eine Zerstäubungsstellung gegenüber den vorerwähnten Magnetmitteln und innerhalb der vorerwähnten Zerstäubungszone zu bringen und mit in der Beschichtungskammer befindlichen Mitteln zum horizontalen Abstützen der Substrate und zum Transportieren dieser an den Magnetmitteln vorbei, damit diese Substrate des zerstäubte Material empfangen.

Aufgabe der vorliegenden Erfindung ist es, eine Vorrichtung der eingangs genannten Art zu schaffen, bei der ein Verlust von Targetmaterial in Folge einer Belegung von Innenwandpartien der Prozeßkammer oder von in der Prozeßkammer angeordneten Blenden oder Substrathalterungen ausgeschlossen ist und die hohe Beschichtungsraten ermöglicht, so daß ein besonders hoher Substratdurchsatz erfolgen kann.

Diese Aufgabe wird erfindungsgemäß dadurch gelöst, daß das Target als Hohlzylinder oder Rohrstück ausgebildet ist, dessen eine stirnseitige Öffnung von einem flachen Kreisscheibenstück verschlossen ist, wobei zwei jeweils einen geschlossenen Ring bildende Reihen von Permanentmagneten vorgesehen sind, von denen die erste geschlossene Reihe die kreiszylindrische Partie des Targets mit Abstand umschließt und die zweite geschlossene Reihe mit Abstand zum die Bodenpartie des Targets bildenden Kreisscheibenstück und koaxial zur Rotationsachse des Hohlzylinders angeordnet ist, wobei jeweils beide Magnetreihen mit einem Joch aus ferromagnetischem Werkstoff zusammenwirken, deren Polschuhe jeweils an einem das zylindrische und das den Boden bildende Kreisscheibenstück des Targets von außen einhüllenden Gehäuse aus nichtmagnetischem Werkstoff anliegen.

Vorzugsweise wirkt die die kreiszylindrische Partie des Targets ringförmig umschließende erste Reihe von Permanentmagneten mit einem im Querschnitt U-förmigen ersten Joch zusammen, wobei die beiden Polschuhe als sich flanschförmig radial nach innen zu bis an das das Target umschließende Gehäuse erstreckende Teile ausgebildet sind, wobei das die beiden Polschuhe verbindende Mittelteil des Jochs ein Kreisring ist, und die erste Magnetreihe in dieses Mittelteil einbezogen oder eingefügt ist.

Mit Vorteil ist das am kreisscheibenförmigen Boden des Targets oder an dem diesen abdeckenden Ebenenstück des Gehäuses aus nicht magnetischem Werkstoff anliegende zweite Joch aus ferromagnetischem Material als flaches kreiszylindrisches Teil mit einer in das dem Target zugekehrten Ebenenstück eingeschnittenen kreisringförmigen Nut oder Ausnehmung ausgebildet, wobei die zweite Magnetreihe in das Rückenteil des Jochs einbezogen oder eingefügt ist, das sich in einer Ebene lotrecht zur Rotationsachse des Targets erstreckt.

Weitere Einzelheiten und Merkmale sind in den Patentansprüchen näher beschrieben und gekennzeichnet.

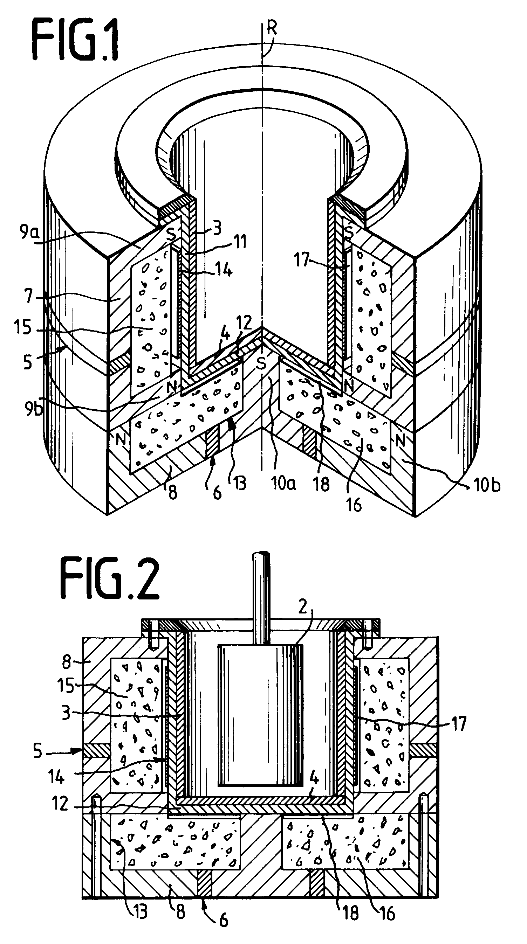

Die Erfindung läßt die verschiedensten Ausführungsmöglichkeiten zu; eine davon ist in der anhängenden Zeichnung in Fig. 1 schematisch, in perspektivischer Ansicht und im Teilschnitt und außerdem in Fig. 2 im Längsschnitt dargestellt.

Die Kathode gemäß den Figuren 1 und 2 besteht aus einem Target in Gestalt eines rohrförmigen Teils 3, aus dem zu zerstäubenden Material, (z. B. Gold), wobei der rohrförmige Teil (3) von einem Kreisscheibenstück 4 nach unten zu verschlossen ist, einem das Target 3, 4 umschließenden topfförmigen Gehäuse 11, 12 aus nicht ferromagnetischem Werkstoff, (z. B. Kupfer), einer das rohrförmige Teil (3) teilweise umschließenden Manschette 14 aus ferromagnetischem Werkstoff, (z. B. Eisen), den beiden Jochs 7, 8, deren Polschuhe 9a, 9b bzw. 10a, 10b mit ihren Stirnflächen jeweils am Gehäuse 11 anliegen und den Einsätzen aus Kunststoff, die jeweils in die Ringräume 15, 16 eingelegt sind und diese bis auf die Kühlkanäle 17, 18 ausfüllen.

Die in der Zeichnung dargestellte Kathode ist in einer Vakuumkammer (nicht näher dargestellt) angeordnet, wobei das Substrat 2 von oben her in den vom Target 3, 4 umschlossenen Raum eingeführt wird. Die (ebenfalls nicht dargestellte) Stromversorgung ist einerseits an das Joch 8 und andererseits an das Substrat 2 angeschlossen, so daß im Ringraum zwischen dem Substrat 2 und dem Target 3, 4 ein Plasma zündet und der Partikelstrom sich vollständig vom Target 3, 4 zum Substrat bewegt.

### Bezugszeichenliste

- 2: Substrat
- 3: Target, Zylindrische Stücke
- 4: Kreisscheibenstück, Targetboden
- 5: Magnetreihe
- 6: Magnetreihe
- 7: Joch
- 8: Joch
- 9a, 9b: Rohrstück
- 10a, 10b: Polschuh
- 11: Gehäuse
- 12: Ebenenstück, Bodenteil
- 13: Nut, Ausnehmung
- 14: Manschette
- 15: Ringraum
- 16: Ringraum
- 17: Kühlkanal
- 18: Kühlkanal

## Patentansprüche

1. Vorrichtung zum Beschichten von Substraten (2) mit dünnen Schichten, mit einer Vakuumkammer, einem zu zerstäubenden Target (3, 4), mit Magneten (5, 6) zur Erzeugung eines magnetischen Tunnels vor der zu zerstäubenden Fläche des Targets (3, 4), einem Einlaß für ein Prozeßgas in den Prozeßraum, einer Anode und mit einer Strom-Spannungs-Versorgung zur Erzeugung eines Plasmas vor dem Target (3, 4), wobei das Target (3, 4) als rotationssymmetrischer Körper ausgeformt ist und das Substrat (2) ringförmig umschließt, **dadurch gekennzeichnet**, daß das Target (3) als Hohlzylinder ausgebildet ist, dessen eine stirnseitige Öffnung von einem flachen Kreisscheibenstück (4) verschlossen ist, wobei zwei jeweils einen geschlossenen Ring bildende Reihen von Permanentmagneten (5, 6) vorgesehen sind, von denen die erste geschlossene Reihe (5) die kreiszylindrische Partie des Targets (3) mit Abstand umschließt und die zweite geschlossene Reihe (6) mit Abstand zum die Bodenpartie des Targets (3) bildenden Kreisscheibenstück (4) und koaxial zur Rotationsachse ( R) des Hohlzylinders (3) angeordnet ist, wobei jeweils beide Magnetreihen (5, 6) mit einem Joch (7 bzw. 8) aus ferromagnetischem Werkstoff zusammenwirken, deren Polschuhe (9a, 9b bzw. 10a, 10b) jeweils an einem das zylindrische (3) und das den Boden bildende kreisscheibenförmige Stück (4) des Targets (3, 4) von außen einhüllenden Gehäuse (11) aus nichtmagnetischem Werkstoff anliegen.

2. Vorrichtung nach Anspruch 1, **dadurch gekennzeichnet**, daß die die kreiszylindrische Partie des Targets (3, 4) ringförmig umschließende erste Reihe von Permanentmagneten (5) mit einem im Querschnitt U-förmigen ersten Joch (7) zusammenwirkt, wobei die beiden Polschuhe (9a, 9b) dieses ersten Jochs (7) als sich flanschförmig radial nach innen zu bis an das das Target (3, 4) umschließende Gehäuse (11) erstreckende Teile ausgebildet sind, und das die beiden Polschuhe (9a, 9b) verbindende Mittelteil ein Kreisring ist, wobei die erste Magnetreihe (5) in dieses Mittelteil einbezogen oder eingefügt ist.

3. Vorrichtung nach den Ansprüchen 1 und 2, **dadurch gekennzeichnet**, daß das am kreisscheibenförmigen Boden (4) des Targets (3, 4) oder an dem diesen abdeckenden Ebenenstück (12) des Gehäuses (11) aus nicht magnetischem Werkstoff anliegende zweite Joch (8) aus ferromagnetischem Material als flaches kreiszylindrisches Teil mit einer in das dem Target (3, 4) zugekehrten Stirnfläche eingeschnittenen kreisringförmigen Nut oder Ausnehmung (13) ausgebildet ist, wobei die zweite Magnetreihe (6) in das Rückenteil des Jochs (8) eingefügt ist, das sich in einer Ebene lotrecht zur Rotationsachse (R) des Targets (3) erstreckt.

4. Vorrichtung nach einem oder mehreren der vorhergehenden Ansprüche, **gekennzeichnet durch** eine das Gehäuse (11) zumindest partiell von außen her umschließende Manschette (14) aus ferromagentischem Werkstoff.

5. Vorrichtung nach einem oder mehreren der vorhergehenden Ansprüche, **dadurch gekennzeichnet**, daß die zwischen dem Joch (7 bzw. 8) einerseits und dem Gehäuse (11) andererseits gebildeten Ringräume (15 bzw. 16) zumindest teilweise von diesen Ringräumen (15, 16) angepaßten Einsätzen oder Ringen aus Kunststoff ausgefüllt sind, wobei noch verbleibende Ringspalte oder Kanäle (17 bzw. 18) vom Kühlmittel durchflossen sind.
